Europäisches Patentamt

(19) European Patent Office

Office européen des brevets

(11) Publication number: **0 132 240**
**B1**

## (12) EUROPEAN PATENT SPECIFICATION

(45) Date of publication of patent specification: **24.06.87**

(51) Int. Cl.⁴: **H 01 L 29/72, H 01 L 27/04**

(21) Application number: **84850181.3**

(22) Date of filing: **13.06.84**

(54) Multiple transistor.

(30) Priority: **15.07.83 SE 8304013**

(43) Date of publication of application:
**23.01.85 Bulletin 85/04**

(45) Publication of the grant of the patent:
**24.06.87 Bulletin 87/26**

(84) Designated Contracting States:
**DE FR GB IT**

(56) References cited:
**DE-B-2 356 301**
**FR-A-2 482 368**
**US-A-3 648 130**
**US-A-3 760 239**
**US-A-3 865 648**
**US-A-4 075 039**
**US-A-4 137 109**
**US-A-4 228 448**

**ELECTRONIC ENGINEERING, vol. 50, no. 616,**
**December 1978, pages 89, 91, 92, 94, 96, 97;**
**N.M. RABIN, "Transistors for linear compatible**
**logic".**

(73) Proprietor: **TELEFONAKTIEBOLAGET L M ERICSSON**
**S-126 25 Stockholm (SE)**

(72) Inventor: **Eklund, Klas-Häkan**
**Jungfrudansen 20**
**S-171 56 Solna (SE)**

(74) Representative: **Johnsson, Helge et al**
**Telefonaktiebolaget L M Ericsson**
**S-126 25 Stockholm (SE)**

## Description

### Technical field

The present invention relates to a multiple transistor with common emitter and separate collectors and bases, made using a monolithic integrated technique and preferably intended for use with relatively high voltages and/or currents.

### Background art

In many technical applications it occurs that a large number of substantially similar loads shall each be driven separately by a transistor drive step. This is the case with matix writers where, for example, 14 impression needles are driven by separate magnets. Transistors for this application must withstand voltages in the order of magnitude 100 V.

Another application is the operation of displays, e.g. of the electroluminescent type, which require high voltages.

Requirements of low assembly cost and minimum space makes it desirable to integrate a plurality of drive transistors and, if possible, the associated control and pre-amplifier circuits in one and the same capsule.

In the manufacture of circuits containing N-P-N transistors, the conventional processes start off from a P-doped substrate. A heavily N-doped region is diffused into the substrate, "the bottom diffusion", and has the task of reducing the collector resistance. A weakly N-doped collector layer is then applied by an epitaxial process. P impurities are diffused into this so that the base is formed, after which the emitter region and a deep contact diffusion of $N^+$-type is diffused down to the bottom diffusion. The $N^+$ type emitter region is diffused into the base region.

An insulating $P^+$ diffusion round the transistor right down to the P substrate is arranged for insulating the transistor from possible remaining circuits on the substrate. By putting the substrate and thereby the insulation at the lowest potential of the circuit the transistor will be located in an area which is insulated from the remaining part of the circuit by a back-biased P-N junction.

The space which the insulation diffusion takes up is considerable in transistors intended for high voltages. The thickness of the epitaxial layer must namely be increased for increased voltage, to make room for the deeper depletion region required for the collector-base junction of the transistors. Since the insulation region must thus be diffused further down, the region will require greater space due to the simultaneous lateral diffusion of impurities. It is indeed known to reduce this space by depositing P—type doping substances under the regions where the insulation diffusion from above is to take place later on before applying the epitaxial layer, but the insulation still takes up large space.

It is known to manufacture multiple transistors of the N-P-N type with a common collector. The individual transistors are then separated from each other by contact diffusion regions, all of which reach down to the bottom diffusion which is common to all the transistor elements. The bases and emitters of the individual transistors are diffused into the wells formed by the bottom diffusion and the contact diffusions. No special insulation diffusion is thus required between the transistor elements.

In a multiple transistor with a common collector, the individual loads will always be in the emitter circuits on the transistor elements. In many cases it is desired to have the load in the collector circuit, e.g. in balanced circuits with a common emitter.

Such a transistor cannot be realized with conventional techniques. A transistor with a common collector according to the above could theoretically be driven inverted, but since the emitter would consist of the low-doped epitaxial region, the emitter efficiency and thereby the amplification would be low. the breakdown voltage would also be low, about 5 V.

A possibility of providing an integrated multiple N-P-N transistor with a common emitter has been described in US—A—3865648 which has been taken into account in the first part of claim 1. Similar structures are disclosed in DE—B—2356301 or US—A—3760239 concerning however different semiconductor devices.

It is also known from the Swedish published patent application 8105040-3 to prepare diodes with low leakage to the substrate by utilizing a structure where a second bottom diffusion of opposite conductivity type is laid over the usual bottom diffusion which is normally utilized as collector. An annular contact diffusion is added to this second bottom diffusion to surround the diode cathode which consists of the normal emitter diffusion and associated contact diffusion. The anode consists of the other bottom diffusion which is interconnected with the first bottom diffusion.

### Disclosure of invention

In accordance with the invention it is possible to provide a multiple transistor with a common emitter solving the problem of miniaturization and simplification by avoiding special insulation diffusions between the individual transistor elements while the transistor can withstand high voltages. In this connection, use is made of the particular features of the diode structure illustrated in the above Swedish published specification, and the characterizing features of the invention are apparent from the appended claims.

### Description of figure

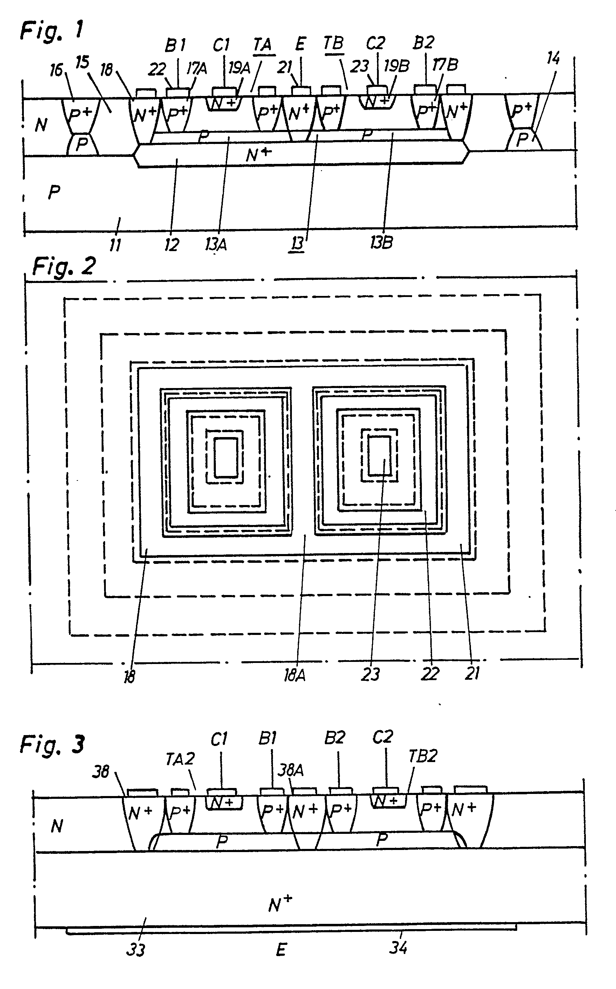

A monolitic integrated multiple transistor implemented in accordance with the invention is seen in section in Figure 1 and in plan view seen from above in Figure 2. Figure 3 illustrates a simplified variant of the circuit according to Figures 1 and 2.

Best mode for carrying out the invention

In Figure 1 the numeral 11 designates a P substrate of substantially the same kind as is used in the manufacture of integrated circuits. A highly doped N$^+$ layer is diffused into the substrate 11 to form a bottom diffusion 12. A P—type bottom diffusion 13 lies above the bottom diffusion 12, this P—type diffusion being applied in the same step as the lower portion 14 of possible insulation diffusions which insulate the multiple transistor from possible other components which can be placed on the same substrate. A low-doped N layer 15 is applied epitaxially over the substrate, and its thickness depends on the desired voltage resistance of the transistors. In the epitaxial layer there are diffused a plurality of P$^+$ type contact diffusions in the form of closed interior frames 17A, 17B which reach down to the upper bottom diffusion 13, these contact diffusions being formed in the same process step as the possible upper part 16 of the insulation diffusion. Along the interior frames 17A, 17B there is a contact diffusion in the form of a frame 18 having transverse portions 18A (Figure 2) which reach down to the lower bottom diffusion 12. The frames 18, 18A entirely surround the frames 17A, 17B. The frames 18, 18A and 17A and 17B are suitably laid so close to each other that the respective doping substances partially penetrate into the adjacent contact diffusion on diffusion.

· According to Figure 2, the diffusion region 18, 18A will thus extend (18) round the edge of the bottom diffusion 12 and also separate the frames 17A and 17B from each other. The upper bottom diffusion 13 will therefore be separated into parts 13A, 13B by the N$^+$ layer of the contact diffusion 18A. N$^+$ layers 19A and 19B are diffused into the compartments formed by the frames 17A, 17B.

The individual transistors TA and TB in the multiple transistor have a common emitter consisting of the first bottom diffusion 12. The emitter area will usually be greater here than for corresponding transistors of conventional type, but for relatively high emitter currents it is the emitter periphery which mainly determines the ability to withstand current, so that the larger emitter area will only marginally affect the size of the transistor. The base of the transistor elements comprise the separated parts 13A and 13B of the upper bottom diffusion. The collectors consist of the parts of the epitaxial layer 15 enclosed by the frames 17A, 17B, which are provided with the N$^+$ type contact diffusions 19A, 19B. Emitter (E), base (B1, B2) and collector (C1, C2) connections are made with metal contacts 21, 22, 23 of the usual kind.

The manufacturing steps for producing this multiple transistor do not deviate from those applied to integrated transistors intended for high voltage, and they have been previously described in the literature.

Multiple transistors of the kind described in conjunction with Figures 1 and 2 can be easily combined with logical circuits and pre-amplifiers of a kind which can be carried out with the illustrated technique. It is thus possible for example to use bipolar logic, for example of the TTL type which is separated from the multiple transistor by an insulation frame 14, 16.

As is conventional in integrated circuits, the multiple transistor according to Figures 1 and 2 has the connection 18 of the lower bottom diffusion 12 taken to the upper side of the substrate. This naturally results in a given bottom voltage determined by the resistance of the contact diffusion 18. An embodiment is illustrated in Figure 3 where a considerably lower bottom voltage can . be obtained. Here the substrate 33 is of the N$^+$ type and the emitter connection 34 is made directly to the rear side of the highly doped substrate.

In the same way as illustrated in Figure 1, there is a P type bottom diffusion on the substrate 33, as well as an epitaxial layer, P$^+$ type contact frames and N$^+$ type collector contact diffusions. A deeply diffused outer frame 38, 38A corresponds to the frame 18, 18A in Figures 1 and 2, but in this case it has no contact function due to the emitter contact 34 being made on the rear side of the substrate, this diffusion thus having the exclusive task of insulating the individual transistor elements TA2, TB2 from each other and preventing leakage of holes from a saturated transistor. A lowering of the saturation voltage by a factor of 2—3 has been observed with a multiple transistor according to Figure 3 compared with the embodiment illustrated in Figure 1.

A further advantage is that a plurality of manufacturing steps can be reduced by the bottom diffusion 12 (and possible insulation frames) becoming superfluous.

When the substrate is common and can easily be given a fixed potential which is the lowest in the circuit, e.g. earth (ground) it is possible to combine the multiple transistor with controlling and driving circuits using MOS technique. The MOS circuits are then applied conventially in the epitaxial layer, either directly into it (P-MOS) or in diffused-in P wells (N-MOS).

The gain in area compared with previously known multiple transistors can be considerable. For example, if 4—5 transistors are placed on the same P-insulated island according to Figure 1, the space required for P insulation can be neglected and the surface requirement will be about three times less than for corresponding multiple transistors, where all the transistors are entirely insulated from each other. A further area gain can be made with the embodiment according to Figure 3.

It is of course possible to manufacture a multiple P-N-P transistor in a corresponding manner by starting from a substrate of the opposite conductivity type (N in Figures 1 and 2, P$^+$ in Figure 3) and carry out the dopings with substances of opposite conductivity type.

**Claims**

1. Multiple transistor with a common emitter and separate isolated collectors, including a substrate (11; 33) with an epitaxial layer (15) located on it, a highly doped emitter layer (12; 33) of a first conductivity type (N), a plurality of base regions (13A, 13B) of the second conductivity type (P), the base regions being arranged in the epitaxial layer and the emitter layer lying under the base regions, a plurality of collector regions disposed on the base regions and extending to the free surface of the epitaxial layer (15), a plurality on inner annular regions (17A, 17B) of the second conductivity type (P), each of them entirely surrounding one of the collector regions and being connected to the corresponding base region (13A, 13B) and an outer annular highly doped diffusion region (18, 18A; 38, 38A) of the first conductivity type (N) disposed along the outer edge of each inner annular region (17A, 17B), entirely surrounding it and reaching down to the emitter layer (12; 33), characterized in that the epitaxial layer (15) is of the first conductivity type (N), in that the base regions (13A, 13B) are derived from a bottom diffusion layer (13) in the epitaxial layer (15), in that a plurality of collector contact diffusion regions (19A, 19B) are disposed on the free surface of the epitaxial layer, and in that the inner annular regions (17A, 17B) consist of highly doped contact diffusion regions reaching down to the corresponding base regions (13A, 13B).

2. Multiple transistor as claimed in claim 1, characterized in that the emitter layer consists of a second highly doped bottom diffusion layer (12) of the first conductivity type (N) arranged in a substrate (11) of the second conductivity type (P).

3. Multiple transistor as claimed in claim 2, characterized in that all electrical connections (21, 22, 23) are located on the free surface of the epitaxial layer (15).

4. Multiple transistor as claimed in claim 1, characterized in that the emitter layer consists of the substrate (33) which is of a highly doped material of the first conductivity type (N), the emitter contact (34) being connected to the substrate surface facing away from the epitaxial layer (15).

**Patentansprüche**

1. Mehrfachtransistor mit einem gemeinsamen Emitter und getrennten isolierten Kollektoren, mit einem Substrat (11; 33) mit darauf angeordneter epitaxialer Schicht (15), einer hochdotierten Emitterschicht (12; 33) eines ersten Leitfähigkeitstyps (N), einer Vielzahl von Basisbereichen (13A, 13B) des zweiten Leitfähigkeitstyps (P), wobei die Basisbereiche in der epitaxialen Schicht angeordnet sind und die Emitterschicht unter den Basisbereichen liegt, einer Vielzahl van Kollektorbereichen, welche auf den Basisbereichen angeordnet sind und sich zu der freien Oberfläche der epitaxialen Schicht (15) erstrecken, einer Vielzahl von enneren Ringbereichen (17A, 17B) des zweiten Leitfähigkeitstyps (P), von denen jeder einen der kollektorbereiche umgibt und mit den zugehörigen Basisbereichen (13A, 13B) verbunden ist, und einem äußeren ringförmigen hochdotierten Diffusionsbereich (18, 18A; 38, 38A) des ersten Leitfähigkeitstyps (N), welcher entlang der äußeren Kante jedes inneren Ringbereichs (17A, 17B) angeordnet ist, diesen vollständig umgibt und zu der Emitterschicht (12; 33) hinunterreicht, dadurch gekennzeichnet, daß die epitaxiale Schicht (15) vom ersten leitfähigkeitstyp (N) ist, daß die Basisbereiche (13A, 13B) von einer Bodendiffusionsschicht (13) in der eptiaxialen Schicht (15) abgeleitet sind, daß eine Vielzahl von Kollektorkontaktdiffusionsbereichen (19A, 19B) an der freien Oberfläche der epitaxialen Schicht angeordnet sind, und daß die inneren Ringbereiche (17A, 17B) aus hochdotierten Kontakdiffusionsbereichen bestehen, die zu den entsprechenden Basisbereichen (13A, 13B) hinunterreichen.

2. Mehrfachtransistor nach Anspruch 1, dadurch gekennzeichnet, daß die Emitterschicht aus einer zweiten hochdotierten Bodendiffusionsschicht (12) des ersten Leitfähigkeitstyps (N) besteht, die in em Substrat (11) des zweiten Leitfähigkeitstyps (P) angeordnet ist

3. Mehrfachtransistor nach anspruch 2, dadurch gekennzeichnet, daß alle elektischen Verbindungen (21, 22, 23) auf der freien Oberfläche der epitaxialen Schicht (15) angeordnet sind.

4. Mehrfachtransistor nach Anspruch 1, dadurch gekennzeichnet, daß die Emitterschicht aus dem Substrat (33) besteht, welches aus einem hochdotierten Material des ersten Leitfähigkeitstyps (N) ist, wobei der Emitterkontakt (34) mit der Substratoberfläche von der epitaxialen Schicht (15) wegweisend verbunden ist.

**Revendications**

1. Transistor multiple comportant un émetteur commun et des collecteurs séparés et isolés, comprenant un substrat (11; 33) avec une couche épitaxiale (15) formée sur ce substrat, une couche d'émetteur fortement dopée (12; 33) d'un premier type de conductivité (N), un ensemble de régions de base (13A, 13B) du second type de conductivité (P), les régions de base étant formées dans la couche épitaxiale et la région d'émetteur se trouvant sous les régions de base, un ensemble de régions de collecteur formées sur les régions de base et s'étendant jusqu'à la surface libre de la couche épitaxiale (15), un ensemble de régions annulaires intérieures (17A, 17B) du second type de conductivité (P), chacune d'elles entourant entièrement l'une des régions de collecteur et étant connectée à la région de base correspondante (13A, 13B), et une région de diffusion annulaire extérieure fortement dopée (18, 18A; 38, 38A), du premier type de conductivité (N), formée le long du bord extérieur de chaque région annulaire intérieure (17A, 17B), entourant entièrement cette région annulaire intérieure et descendant jusqu'à la couche d'émetteur (12; 33), caractérisé en ce que la couche épitaxiale (15) est du premier type de conductivité (N), en ce que les régions de base (13A, 13B) sont formées à partir d'une couche de diffusion de fond (13) dans la couche épitaxiale (15), en ce qu'un ensemble de régions de diffusion de contact de collecteur (19A, 19B) sont formées sur la surface libre de la couche épitaxiale, et en ce que les régions annulaires intérieures (17A, 17B) sont constituées par des régions de diffusion de contact fortement dopées qui descendent jusqu'aux régions de base correspondantes (13A, 13B).

2. Transistor multiple selon la revendication 1, caractérisé en ce que la couche d'émetteur consiste en une seconde couche de diffusion de fond fortement dopée (12) du premier type de conductivité (N), qui est formée dans un substrat (11) du second type de conductivité (P).

3. Transistor multiple selon la revendication 2, caractérisé en ce que toutes les connexions électriques (21, 22, 23) se trouvent sur la surface libre de la couche épitaxiale (15).

4. Transistor multiple selon la revendication 1, caractérisé en ce que la couche d'émetteur est constituée par le substrat (33) qui consiste en une matière fortement dopée du premier type de conductivité (N), et le contact d'émetteur (34) est connecté à la surface du substrat qui est opposée à la couche épitaxiale (15).

Fig. 1

B1   C1   TA   E   TB   C2   B2

16  15  18  22  17A  19A  21  23  19B  17B  14

N   P+   N+ P+  N+   P+ N+ P+   P+   P+ N+   P+

P   P   N+   P   P

P

11   12   13A   13   13B

Fig. 2

18   18A   23   22   21

Fig. 3

C1   B1   B2   C2

38   TA2   38A   TB2

N   N+ P+   N+   P+ N+ P+   N+   P+ N+

P   P

N+

33   E   34